# EUROPEAN PATENT APPLICATION

(11) **EP 3 962 257 A1**
(43) Date of publication of application: **02.03.2022**
(21) Application number: 21806614.0
(22) Date of filing: 21.01.2021
(51) Int. Cl.: H05K 7/20, F28D 21/00

(54) **HEAT DISSIPATION DEVICE, AND HEAT DISSIPATION AND HEATING SYSTEM**

(30) Priority: 28.05.2020 CN 202010467087
(71) Applicant: Hangzhou Dareruohan Technology Co., Ltd., Hangzhou, Zhejiang 311199 (CN)
(72) Inventor: LI, Risheng, Beijing 100020 (CN); LIU, Yunfeng, Beijing 100020 (CN); WANG, Liedong, Beijing 100020 (CN); XU, Jun, Beijing 100020 (CN)
(74) Representative: Wang, Bo
(86) International application number: PCT/CN2021/073161
(87) International publication number: WO 2021/238245

(57) **Abstract**

The present disclosure may disclose cooling devices, including a cooling plate. One or more cooling pipelines may be formed inside the cooling plate. The cooling pipelines may include an inlet pipe, an outlet pipe and one or more connecting pipes. The inlet pipe and the outlet pipe may traverse the cooling plate along a first direction and one end of each of the inlet pipe and the outlet pipe may be blocked. The one or more connecting pipes may traverse the cooling plate along a second direction and both ends of each of the one or more connecting pipes may be blocked, and the inlet pipe and the outlet pipe may be interconnected with two end portions of each of the one or more connecting pipes, respectively, so that liquid may flow in the cooling device.

## Description

### CROSS-REFERENCE

The present disclosure claims priority to Chinese Application No. 202010467087.9, filed on May 28, 2020, the contents of which are hereby incorporated by reference.

### TECHNICAL FIELD

The present disclosure relates to heat dissipation, and more particularly, relates to cooling devices and cooling and heating systems.

### BACKGROUND

A cooling device is normally used to dissipate heat from a device that produces large amounts of heat (such as chips, central processing units (CPUs), graphics processing units (GPUs), application-specific integrated circuits (ASICs), etc.) to prevent the device from overheating during use, thus ensuring the normal operation of the device. The cooling device can generally use liquid as a coolant, and the coolant can flow in pipelines of the cooling device and absorb the heat generated by the device.

### SUMMARY

One of the embodiments of the present disclosure provides cooling devices, including a cooling plate. One or more cooling pipelines may be formed inside the cooling plate, and the cooling pipelines may include an inlet pipe, an outlet pipe and one or more connecting pipes. The inlet pipe and the outlet pipe may traverse the cooling plate along a first direction, and one end of each of the inlet pipe and the outlet pipe may be blocked. The one or more connecting pipes may traverse the cooling plate along a second direction, both ends of each of the one or more connecting pipes may be blocked, the one or more connecting pipes may be arranged at intervals in the first direction, and the inlet pipe and the outlet pipe may be interconnected with two end portions of each of the one or more connecting pipes, respectively, so that a liquid may flow in the cooling device from an unblocked end of the inlet pipe, flow through the connecting pipes, and flow out of the cooling device from an unblocked end of the outlet pipe.

In some embodiments, the first direction may be perpendicular to the second direction.

In some embodiments, each of the blocked ends of the inlet pipe, the outlet pipe, and the one or more connecting pipes may be blocked using a blocking member, and the blocking member may connect with at least one of the inlet pipe, the outlet pipe, or the one or more connecting pipes through threaded connection.

In some embodiments, the unblocked end of the inlet pipe and the unblocked end of the outlet pipe may be located on opposite sides of the cooling plate.

In some embodiments, a cross-section of at least one of the inlet pipe, the outlet pipe, or the connecting pipes may be circular or elliptical.

In some embodiments, the cooling device may include two cooling plates, and a device to be cooled may be arranged between the two cooling plates.

In some embodiments, the cooling device may include a plurality of cooling plates, and the plurality of cooling plates may be fixedly connected by one or more plate connecting members traversing the plurality of the cooling plates, and a device to be cooled may be arranged between each two adjacent cooling plates.

One of the embodiments of the present disclosure provides cooling and heating systems, including a cooling device, the cooling device including a cooling plate, one or more cooling pipelines being formed inside the cooling plate, and the cooling pipelines including an inlet pipe, an outlet pipe and one or more connecting pipes, wherein the inlet pipe and the outlet pipe may traverse the cooling plate along a first direction, and one end of each of the inlet pipe and the outlet pipe may be blocked; and the one or more connecting pipes may traverse the cooling plate along a second direction, both ends of each of the one or more connecting pipes may be blocked, the one or more connecting pipes may be arranged at intervals in the first direction, and the inlet pipe and the outlet pipe may be interconnected with two end portions of each of the one or more connecting pipes, respectively, so that a liquid may flow in the cooling device from an unblocked end of the inlet pipe, flow through the connecting pipes, and flow out of the cooling device from an unblocked end of the outlet pipe; and a heat radiator connecting with the cooling device, the liquid flowing out of the outlet pipe of the cooling device flowing through the heat radiator.

In some embodiments, the first direction may be perpendicular to the second direction.

In some embodiments, each of the blocked ends of the inlet pipe, the outlet pipe, and the one or more connecting pipes may be blocked using a blocking member, and the blocking member may connect with at least one of the inlet pipe, the outlet pipe, or the one or more connecting pipes through threaded connection.

In some embodiments, the unblocked end of the inlet pipe and the unblocked end of the outlet pipe may be located on opposite sides of the cooling plate.

In some embodiments, a cross-section of at least one of the inlet pipe, the outlet pipe, or the connecting pipes may be circular or elliptical.

In some embodiments, the cooling device may include two cooling plates, and a device to be cooled may be arranged between the two cooling plates.

In some embodiments, the cooling device may include a plurality of cooling plates, and the plurality of cooling plates may be fixedly connected by one or more plate connecting members traversing the plurality of the cooling plates, and a device to be cooled may be arranged between each two adjacent cooling plates.

In some embodiments, the cooling device may be arranged adjacent to the device to be cooled, so that the liquid flowing through the cooling device can absorb heat from the device to be cooled. An outlet of the cooling device may be connected with an inlet of the heat radiator, and an inlet of the cooling device may be connected with an outlet of the heat radiator.

In some embodiments, a cross-sectional area and a length of the one or more connecting pipes configured in the cooling device may be within preset ranges, so that a temperature difference between the liquid flowing into the cooling device from the inlet of the cooling device and the liquid flowing out of the cooling device from the outlet of the cooling device may be smaller than a preset threshold.

### BRIEF DESCRIPTION OF THE DRAWINGS

The present disclosure is further illustrated in terms of exemplary embodiments. These exemplary embodiments are described in detail with reference to the drawings. These embodiments are non-limiting exemplary embodiments, in which like reference numerals represent similar structures, and wherein:
FIG. 1 is a schematic structural diagram illustrating cooling pipelines of a cooling device according to some embodiments of the present disclosure;
FIG. 2 is a schematic three-dimensional structural diagram illustrating a cooling device according to some embodiments of the present disclosure;
FIG. 3 is a schematic structural diagram illustrating two cooling plates and a device to be cooled according to some embodiments of the present disclosure;
FIG. 4 is a schematic structural diagram illustrating a plurality cooling plates and devices to be cooled according to some embodiments of the present disclosure; and
FIG. 5 is a schematic structural of a cooling and heating system according to some embodiments of the present disclosure.

### DETAILED DESCRIPTION

In order to make the purpose, technical solutions, and advantages of the present disclosure clearer, the present disclosure is further illustrated in detail with reference to the drawings and embodiments. It should be understood that the specific embodiments are merely used to illustrate the present disclosure, and not intended to limit the present disclosure.

On the contrary, the present disclosure covers any alternatives, modifications, equivalent methods and solutions defined by the claims in the spirit and scope of the present disclosure. Further, in order to enable the public to have a better understanding of the present disclosure, some specific details are described in detail in the detailed description of the present disclosure below. Those skilled in the art can fully understand the present disclosure without the description of these details.

The embodiment of the present disclosure relates to cooling devices. Cooling pipelines arranged in the cooling device may include an inlet pipe, an outlet pipe and one or more connecting pipes. The inlet pipe and the outlet pipe may traverse a cooling plate along a first direction and one end of each of the inlet pipe and the outlet pipe may be blocked. The one or more connecting pipes may traverse the cooling plate along a second direction. Both ends of each of the one or more connecting pipes may be blocked, and the inlet pipe and the outlet pipe may be interconnected with two end portions of each of the one or more connecting pipes, respectively. Through this arrangement, heat dissipation efficiency of the cooling device can be improved and the heat dissipation effect is ensured, and a temperature difference of the liquid between the time when the liquid flows into the cooling device from an inlet and the time when the liquid flows out of the cooling device from an outlet can be reduced, so that the liquid flowing out of the cooling device from the outlet can be used for heating directly, then the liquid can be cooled in the cooling device after heating, thus realizing cyclic use of the liquid and recycling of the heat from a device to be cooled using the cooling device. In addition, the cooling pipelines may be formed simply and efficiently in the cooling plate by drilling holes in the cooling plate, which may reduce the manufacturing difficulty. The cooling device in the present disclosure may be applied to dissipate heat from devices such as electronic products, servers' chip boards, central processing units (CPUs), graphics processing units (GPUs), application-specific integrated circuits (ASICs), or the like.

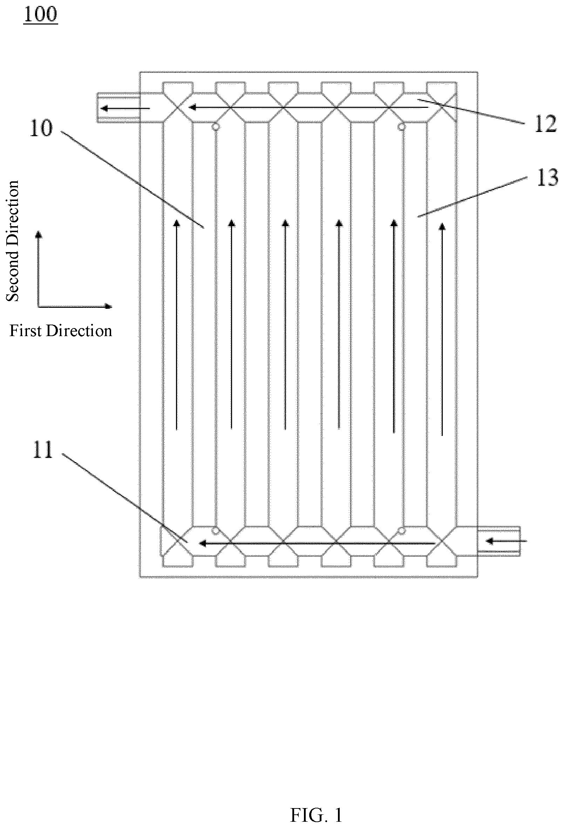

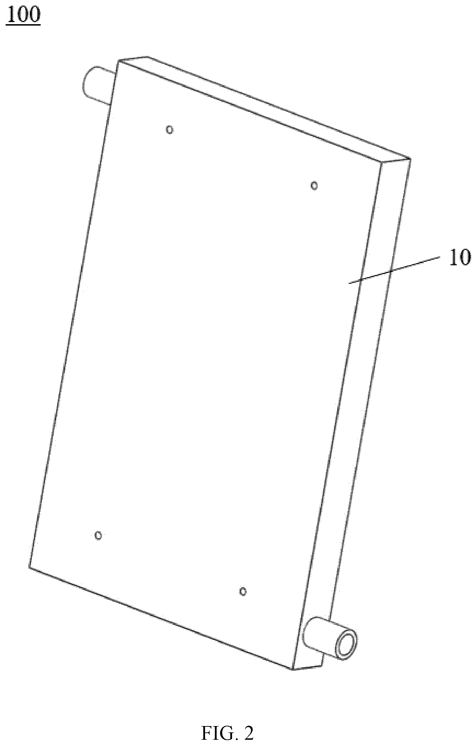

FIG. 1 is a schematic structural diagram illustrating cooling pipelines of a cooling device according to some embodiments of the present disclosure. FIG. 2 is a schematic three-dimensional structural diagram illustrating a cooling device according to some embodiments of the present disclosure. As shown in FIG. 1 and FIG. 2, a cooling device 100 may include a cooling plate 10, and one or more cooling pipelines may be formed inside the cooling plate 10. The cooling pipelines may include an inlet pipe 11, an outlet pipe 12, and a plurality of connecting pipes 13. The inlet pipe 11 and the outlet pipe 12 may traverse the cooling plate 10 along a first direction and one end of each of the inlet pipe and the outlet pipe may be blocked. The ends of the inlet pipe and/or the outlet pipe may be on two surfaces (e.g., two opposite surfaces) of the cooling plate. The one or more connecting pipes 13 may traverse the cooling plate 10 along a second direction and both ends of each of the one or more connecting pipes may be blocked. The ends of each of the one or more connecting pipes may also be on two surfaces (e.g., two opposite surfaces) of the cooling plate. The one or more connecting pipes 13 may be arranged at intervals in the first direction. The first direction and the second direction are shown with reference to FIG. 1. The inlet pipe 11 and the outlet pipe 12 may be interconnected with two end portions of each of the one or more connecting pipes 13, respectively. The two end portions of each of the one or more connecting pipes 13 may be within the cooling plate 10. Arrows in the cooling pipelines in FIG. 1 show a flow direction of a liquid. The liquid may flow in the cooling device from an unblocked end of the inlet pipe 11, flow through the connecting pipe(s) 13, and flow out of the cooling device from an unblocked end of the outlet pipe 12. Those skilled in the art may determine a specific count, a length, and a distance between two adjacent connecting pipes 13 according to actual working conditions (such as thickness of the cooling device 10, a length of the cooling device 10 along the first direction, heat from a device to be cooled, etc.) and determine lengths of the inlet pipe 11 and the outlet pipe 12 and positions of the inlet pipe 11 and the outlet pipe 12 relative to the cooling device 10. Merely by way of example, when the heat from the device to be cooled is relatively large, a larger count of connecting pipes 13 may be arranged and the distance between two adjacent connecting pipes 13 may be relatively small. In some embodiments, the one or more connecting pipes 13 may be arranged in parallel to each other at equal intervals. The cooling device 10 may be made of material that is easy to conduct heat, such as copper or aluminum. In some embodiments, the liquid may be used for absorbing the heat from the device to be cooled, and the liquid may be liquid, such as water, antifreeze, or the like, that can be used to absorb heat.

Since the cooling device 100 of the present disclosure has a high heat dissipation efficiency, a temperature difference of the liquid between the time when the liquid flows into the cooling device from the inlet of the cooling device 100 and the time when the liquid flows out of the cooling device from the outlet of the cooling device 100 may be small. The liquid flowing out of the cooling device from the outlet of the cooling device can be directly used for heating (e.g., a device to be heated, a room, etc.). Then the liquid can be returned to the cooling device for cooling the device to be cooled, so as to realize liquid recycling.

In some embodiments, the first direction may be perpendicular to the second direction. In other embodiments, an included angle between the first direction and the second direction may be other angles, such as 60°, 75°, 85°, or the like. In some embodiments, as shown in FIGs. 1 and 2, the first direction is perpendicular to the second direction, and the cooling plate 10 is rectangular. The inlet pipe 11 and the outlet pipe 12 are both parallel to shorter sides of the cooling plate 10, and the one or more connecting pipes 13 are parallel to longer sides of the cooling plate 10. In other embodiments, the cooling plate 10 may also be circular, triangular, polygonal, or the like. A shape of the cooling plate 10 may be completely or partially the same as a shape of the device to be cooled 200, so as to save cost of the cooling plate 10, and the cooling plate 10 may have a better heat dissipation effect.

In some embodiments, the inlet pipe 11, the outlet pipe 12, and the connecting pipe(s) 13 may be blocked in various ways. In some embodiments, each of the blocked ends of the inlet pipe 11, the outlet pipe 12, and the one or more connecting pipes 13 may be blocked using a blocking member. The blocking member may connect with at least one of the inlet pipe 11, the outlet pipe 12, or the one or more connecting pipes 13 through threaded connection. In some embodiments, the blocking member may be a screw. The threaded connection of the blocking member with the at least one of the inlet pipe 11, the outlet pipe 12, or the one or more connecting pipes 13 may improve blocking effect of the blocking member and effectively prevent the liquid from leaking out of the cooling pipelines from the blocking member, and the threaded connection structure may be convenient for installation and disassembly. In some alternative embodiments, the blocking members may connect with the at least one of the inlet pipe 11, the outlet pipe 12, or the one or more connecting pipes 13 through bonding connection, welding connection, clamping connection, etc. For example, as shown in FIG. 1, the blocking members that block the inlet pipe 11, the outlet pipe 12, and/or the one or more connecting pipes 13 may be a blocking plate connected with the cooling plate 10. In some embodiments, a leak-proof gasket may be provided between a blocking member and the cooling plate 10 to further prevent the liquid from leaking out of the cooling pipelines from the blocking member. The leak-proof gasket may be made of rubber, latex, resin, etc.

In some embodiments, the unblocked end of the inlet pipe 11 (i.e., the inlet) and the unblocked end of the outlet pipe 12 (i.e., the outlet) may be located on opposite sides of the cooling plate 10. In this way, each cooling pipeline may be fully utilized, so as to improve the heat dissipation effect of the cooling device 100 on the device to be cooled 200. Merely by way of example, when the cooling plate 10 is rectangular, the unblocked end of the inlet pipe 11 and the unblocked end of the outlet pipe 12 may be located on two opposite sides of the rectangle. As another example, when the cooling plate 10 is circular, positions of the unblocked end of the inlet pipe 11 and the unblocked end of the outlet pipe 12 may be symmetrical with respect to a center of the circle. In some alternative embodiments, the inlet and the outlet may also be located on one same side or adjacent sides of the cooling plate 10.

In some embodiments, a cross-section of at least one of the inlet pipe 11, the outlet pipe 12, or the connecting pipes 13 may be circular or elliptical. In other embodiments, a cross-section of at least one of the inlet pipe 11, the outlet pipe 12, or the connecting pipes 13 may also be polygonal (such as quadrilateral, hexagon, octagon, etc.). Compared with at least one of the inlet pipe 11, the outlet pipe 12, or the connecting pipes 13 with polygonal cross-sections, impurities may not accumulate in the pipelines with circular or elliptical cross-sections, which may effectively prevent the cooling pipelines from being blocked by the impurities. In addition, the pipelines with a circular cross-section may be manufactured much more easily.

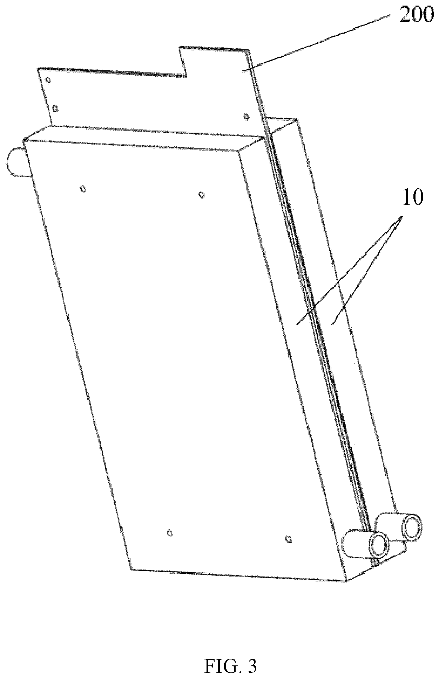

In some embodiments, a cooling device 100 may include two cooling plates 10. FIG. 3 is a schematic structural diagram illustrating two cooling plates and a device to be cooled according to some embodiments of the present disclosure. As shown in FIG. 3, a device to be cooled 200 is arranged between the two cooling plates 10. Merely by way of example, when the device to be cooled 200 is a chip, cooling plates 10 may be provided on both surfaces of the chip, and surfaces of the cooling plates 10 may be attached to the surfaces of the chip, which may ensure a heat dissipation effect of the cooling device 100 on the device to be cooled. The device to be cooled 200 shown in FIG. 3 may be a chip, a chip assembly, a printed circuit board (PCB), or the like.

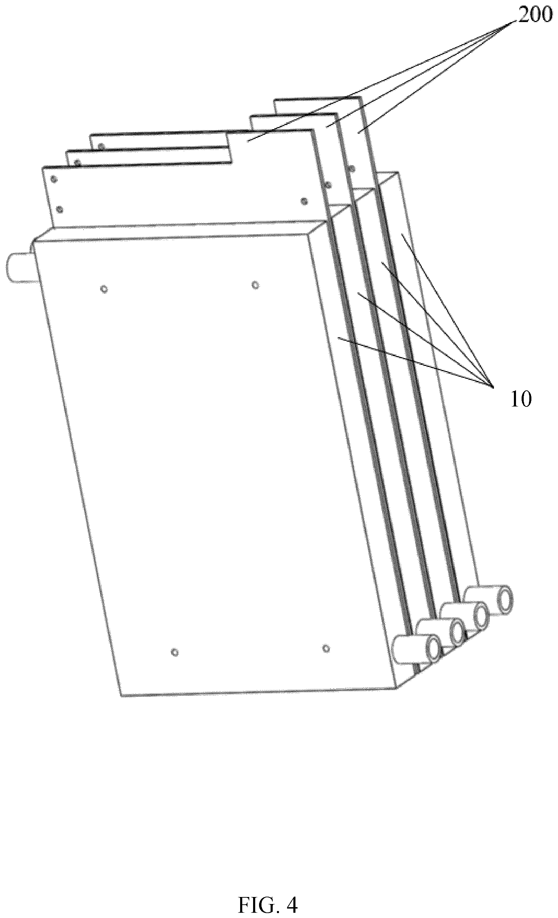

In other embodiments, the cooling device 100 may include a plurality of cooling plates 10. For example, the cooling device 100 may include 3, 5, 6 cooling plates 10, etc. Those skilled in the art may specifically determine a count of cooling plate(s) 10 of the cooling device 100 according to a structure, a size, a count, etc. of the device to be cooled 100. FIG. 4 is a schematic structural diagram illustrating a plurality cooling plates 10 and devices to be cooled 200 according to some embodiments of the present disclosure. As shown in FIG. 4, the plurality of cooling plates 10 are fixedly connected by one or more plate connecting members (not shown in the figure) traversing the plurality of the cooling plates 10, and a device to be cooled 200 is arranged between each two adjacent cooling plates 10, which may reduce the count of cooling plates 10 while a heat dissipation effect of the cooling device 100 on the devices to be cooled 200 is ensured, so that the cooling plates 10 may be fully utilized. In some embodiments, the one or more plate connecting members may be threaded plate connecting members, and a plurality of cooling plates 10 may be fixedly connected by connecting nuts at two ends or one end of each of at least a part of the plate connecting members. The cooling plate 10 between each two adjacent connecting pipes 13 may be provided with through mounting holes penetrating the cooling plates 10 along a thickness direction, and the plate connecting members may pass through the mounting holes. Each of the devices to be cooled 200 as shown in FIG. 4 may include a chip, a chip assembly, a PCB board, or the like.

The beneficial effects of the cooling device disclosed in the present disclosure may include but are not limited to: (1) heat dissipation efficiency can be improved while a heat dissipation effect is ensured, thereby reducing a temperature difference of the liquid between the time when the liquid flows into the cooling device from the inlet of the cooling device and the time when the liquid flows out of the cooling device from the outlet of the cooling device, so that the liquid flowing out of the cooling device can be directly used for heating without treatment, and the heated liquid can be returned to the cooling device again and directly used for heat dissipation, realizing liquid recycling; (2) since the heat dissipation efficiency is high, the cooling device can be applied to dissipate heat from large-power devices to be cooled (such as large-power chips); (3) by arranging a structure of the cooling pipelines inside the cooling device, the cooling pipelines can be processed on the cooling device simply and efficiently by drilling through holes on the cooling plate, reducing the process difficulty; (4) the resistance of the cooling pipeline is small and hardly be blocked, and the flow of the liquid in the cooling pipelines is large, which may lower down requirements on the quality of the liquid; and (5) the recycling and utilization of the heat energy from the device to be cooled can be realized. It should be noted that different embodiments may have different beneficial effects. In different embodiments, the possible beneficial effects may include any combination of one or more of the above, or any other possible beneficial effects that may be obtained.

Some embodiments of the present disclosure provide a cooling and heating system 1000. The cooling and heating system 1000 may include the cooling device 100 of any of the above technical solutions. By using the cooling device 100 of any of the above technical solutions, while the device to be cooled 200 is dissipated, since the temperature difference of the liquid between the time when the liquid flows into the cooling device from the inlet of the cooling device 100 and the time when the liquid flows out of the cooling device from the outlet of the cooling device 100 is relatively small, the cooling and heating system may directly use the liquid of the cooling device 100 for heating after the liquid absorbs the heat from the device to be cooled 200. Then the heated liquid may further be used for heat dissipation directly (e.g., cooling the device to be cooled). In addition, since the cooling device 100 does not require liquid of high quality, a purification device for purifying the liquid may not be used in the cooling and heating system 1000, which may reduce the cost of the cooling and heating system 1000.

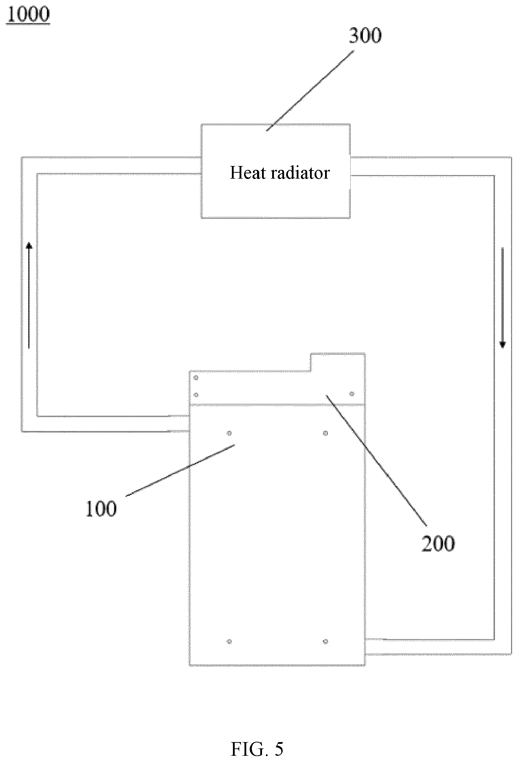

FIG. 5 is a schematic structural of a cooling and heating system according to some embodiments of the present disclosure. As shown in FIG. 5, in some embodiments, the cooling and heating system 1000 may include a device to be cooled 200 and a heat radiator 300. The cooling device 100 may be arranged adjacent to the device to be cooled 200 so that the liquid flowing through the cooling device 100 can absorb heat from the device to be cooled 200. An outlet of the cooling device 100 may be connected with an inlet of the heat radiator 300, and an inlet of the cooling device 100 may be connected with an outlet of the heat radiator 300. The heat radiator 300 may be understood as a heating facility (such as a radiator) installed to keep a space where people live or work in a suitable thermal state. A flow direction of the liquid in the cooling and heating system 1000 is shown by the arrow in FIG. 5. The liquid with a higher temperature may flow into the pipelines of the heat radiator 300, and the liquid may release heat in the pipelines of the heat radiator 300 to increase the temperature of an area where the heat radiator 300 needs to heat. The heat radiator 300 may be used in conjunction with the cooling device 100, and the liquid flowing out of the outlet of the cooling device may be used for heating the heat radiator 300, so as to realize liquid recycling and the utilization of the heat energy from the device to be cooled 200.

In some embodiments, if a cooling plate with only one pipeline for the liquid circulation is used, a temperature difference of the liquid between the time when the liquid flows into the cooling device from the inlet of the cooling device and the time when the liquid flows out of the cooling device from the outlet of the cooling device may be large (for example, it may reach 20°C, 25°C, even 40°C, etc.). In the present disclosure, the cooling pipelines may be arranged according to any of the above technical solutions in FIGs. 1-4, so that while the heat dissipation effect of the device to be cooled 200 by the cooling device 100 is ensured, the temperature difference of the liquid between the time when the liquid flows into the cooling device from the inlet of the cooling device 100 and the time when the liquid flows out of the cooling device from the outlet of the cooling device 100 may be small (for example, the temperature difference may be 2°C, 5°C, 8°C, etc.). If the temperature difference is too large, the cooling device 100 and the heat radiator 300 may not be directly connected for cycling. If the temperature of the liquid flowing out of the cooling device from the outlet of the cooling device 100 is high, even if the temperature of the liquid drops in the heat radiator 300, the temperature of the liquid when it is sent to the heat radiator 300 and flows out of the heat radiator 300 may still be relatively high, and the liquid may not dissipate heat from the device to be cooled 200. In this case, the cycling may not function normally. Therefore, by using the cooling device 100 provided in the embodiments of the present disclosure, since the temperature difference of the liquid between the time when the liquid flows into the cooling device from the inlet of the cooling device 100 and the time when the liquid flows out of the cooling device from the outlet of the cooling device 100 is small, the liquid flowing out of the heat radiator 300 can be directly used for the heat dissipation of the cooling device 100. Thus, the cooling device 100 and the heat radiator 300 can be connected directly to realize liquid recycling, and the cooling and heating system 1000 with a simple structure can recycle and utilize heat energy effectively.

In some embodiments, a cross-sectional area and a length of each of the one or more connecting pipes 13 configured in the cooling device 100 may be within preset ranges, so that the temperature difference of the liquid between the time when the liquid flows into the cooling device from the inlet of the cooling device 100 and the time when the liquid flows out of the cooling device from the outlet of the cooling device 100 may be smaller than a preset threshold. By adjusting the cross-sectional area and the length of the connecting pipes 13, the temperature difference may be adjusted. In some embodiments, a cross section of the connecting pipe(s) 13 may be understood as a cross section of a single connecting pipe. At this time, the above temperature difference may also be adjusted by adjusting a count of the connecting pipe(s) 13. In some embodiments, the cross section of the connecting pipe(s) 13 may be understood as a combination of the cross sections of one or more connecting pipes 13. In some embodiments, the preset threshold of the temperature difference may be 2°C, 3°C, 5°C, 8°C, or the like. In some embodiments, for a specific device to be cooled 200 and a specific liquid temperature and a liquid flow rate (such as a temperature and a flow rate of the liquid flowing into the cooling device 100 from the inlet), a corresponding relationship between the cross-sectional area and the length of the connecting pipe(s) 13 and the temperature difference may be determined by theoretical calculations or experiments, and a corresponding preset range of the cross-sectional area and the length of the connecting pipe(s) may be selected according to the preset threshold of the temperature difference. Then, connecting pipes of specific thicknesses, counts and lengths may be selected, so that the cross-sectional area and the length of each of the one or more connecting pipes 13 may be within the preset range.

In this embodiment, when the cooling device 100 is used in conjunction with different heat radiators 300, the temperature difference of the liquid between the time when the liquid flows into the cooling device from the inlet of the cooling device 100 and the time when the liquid flows out of the cooling device from the outlet of the cooling device 100 may be adjusted by adjusting the cross-sectional area and the length of the connecting pipe(s) 13, so that the cooling device 100 may be used in conjunction with different heat radiators 300 in different cooling and heating systems 100 to improve the general adaptability of the cooling device 100 during use.

Having thus described the basic concepts, it may be rather apparent to those skilled in the art after reading this detailed disclosure that the foregoing detailed disclosure is intended to be presented by way of example only and is not limiting. Although not explicitly stated here, those skilled in the art may make various modifications, improvements and amendments to the present disclosure. These alterations, improvements, and modifications are intended to be suggested by this disclosure, and are within the spirit and scope of the exemplary embodiments of this disclosure.

Moreover, certain terminology has been used to describe embodiments of the present disclosure. For example, the terms "one embodiment," "an embodiment," and/or "some embodiments" mean that a particular feature, structure or characteristic described in connection with the embodiment is included in at least one embodiment of the present disclosure. Therefore, it is emphasized and should be appreciated that two or more references to "an embodiment" or "one embodiment" or "an alternative embodiment" in various parts of this specification are not necessarily all referring to the same embodiment. In addition, some features, structures, or features in the present disclosure of one or more embodiments may be appropriately combined.

Similarly, it should be appreciated that in the foregoing description of embodiments of the present disclosure, various features are sometimes grouped together in a single embodiment, figure, or description thereof for the purpose of streamlining the disclosure aiding in the understanding of one or more of the various embodiments. However, this disclosure does not mean that the present disclosure object requires more features than the features mentioned in the claims. Rather, claimed subject matter may lie in less than all features of a single foregoing disclosed embodiment.

At last, it should be understood that the embodiments described in the present disclosure are merely illustrative of the principles of the embodiments of the present disclosure. Other modifications that may be employed may be within the scope of the present disclosure. Thus, by way of example, but not of limitation, alternative configurations of the embodiments of the present disclosure may be utilized in accordance with the teachings herein. Accordingly, embodiments of the present disclosure are not limited to that precisely as shown and described.

## Claims

1. A cooling device, comprising a cooling plate, one or more cooling pipelines being formed inside the cooling plate, and the cooling pipelines including an inlet pipe, an outlet pipe and one or more connecting pipes, wherein:
the inlet pipe and the outlet pipe traverse the cooling plate along a first direction, and one end of each of the inlet pipe and the outlet pipe is blocked; and
the one or more connecting pipes traverse the cooling plate along a second direction, both ends of each of the one or more connecting pipes are blocked, the one or more connecting pipes are arranged at intervals in the first direction, and the inlet pipe and the outlet pipe are interconnected with two end portions of each of the one or more connecting pipes, respectively, so that a liquid flows in the cooling device from an unblocked end of the inlet pipe, flows through the connecting pipes,and flows out of the cooling device from an unblocked end of the outlet pipe.

2. The cooling device of claim 1, wherein the first direction is perpendicular to the second direction.

3. The cooling device of claim 1, wherein each of the blocked ends of the inlet pipe, the outlet pipe, and the one or more connecting pipes is blocked using a blocking member, and the blocking member connects with at least one of the inlet pipe, the outlet pipe, or the plurality connecting pipes through threaded connection.

4. The cooling device of claim 1, wherein the unblocked end of the inlet pipe and the unblocked end of the outlet pipe are located on opposite sides of the cooling plate.

5. The cooling device of claim 1, wherein a cross-section of at least one of the inlet pipe, the outlet pipe, or the connecting pipes is circular or elliptical.

6. The cooling device of claim 1, wherein the cooling device comprises two cooling plates, and a device to be cooled is arranged between the two cooling plates.

7. The cooling device of claim 1, wherein the cooling device comprises a plurality of cooling plates, and the plurality of cooling plates are fixedly connected by one or more plate connecting members traversing the plurality of the cooling plates, and a device to be cooled is arranged between each two adjacent cooling plates.

8. A cooling and heating system, comprising the cooling device of any one of claims 1-7.

9. The cooling and heating system of claim 8, further including a device to be cooled and a heat radiator, wherein
the cooling device is arranged adjacent to the device to be cooled so that the liquid flowing through the cooling device can absorb heat from the device to be cooled; and
an outlet of the cooling device is connected with an inlet of the heat radiator, and an inlet of the cooling device is connected with an outlet of the heat radiator.

10. The system of claim 9, wherein a cross-sectional area and a length of the one or more connecting pipes configured in the cooling device are within preset ranges, so that a temperature difference between the liquid flowing into the cooling device from the inlet of the cooling device and the liquid flowing out of the cooling device from the outlet of the cooling device is smaller than a preset threshold.
